Europäisches Patentamt

European Patent Office

Office européen des brevets

(19)

(11) Publication number: **0 011 974**
B1

# EUROPEAN PATENT SPECIFICATION

(12)

(45) Date of publication of patent specification: **15.02.84**

(51) Int. Cl.³: **G 11 C 29/00**

(21) Application number: **79302622.0**

(22) Date of filing: **19.11.79**

(54) **Programmable memory device provided with test means.**

(30) Priority: **25.11.78 JP 145829/78**
**25.11.78 JP 145830/78**
**27.11.78 JP 146299/78**

(43) Date of publication of application:
**11.06.80 Bulletin 80/12**

(45) Publication of the grant of the patent:
**15.02.84 Bulletin 84/7**

(84) Designated Contracting States:
**DE FR GB NL**

(56) References cited:

SEMICONDUCTOR TEST SYMPOSIUM;
MEMORY AND LSI, IEEE Computer Society:
November 5-7, 1974, pages 89-112; Cherry Hill,
New Jersey, US Long Beach, WASSER: "What is
necessary for testing "Roms" and "Proms"?

(73) Proprietor: **FUJITSU LIMITED**
**1015, Kamikodanaka Nakahara-ku**
**Kawasaki-shi Kanagawa 211 (JP)**

(72) Inventor: **Fukushima, Toshitaka**
**16-4-442 Shiomidai Isogo-ku**
**Yokohama-shi Kanagawa 235 (JP)**
Inventor: **Koyama, Kazumi**
**17-7 Wakabadai 3-chome Shiroyama-cho**
**Tsukui-gun Kanagawa 220-01 (JP)**
Inventor: **Ueno, Kouki**
**23-10 Umegaoka, Midori-ku**
**Yokohama-shi, Kanagawa 227 (JP)**
Inventor: **Miyamura, Tamio**
**1381 Ida Nakahara-ku**
**Kawasaki-shi Kanagawa 211 (JP)**
Inventor: **Kawabata, Yuichi**
**708 Kashimada Saiwai-ku**
**Kawasaki-shi Kanagawa 211 (JP)**

(74) Representative: **Rackham, Stephen Neil et al,**
**GILL JENNINGS & EVERY 53-64 Chancery Lane**
**London WC2A 1HN (GB)**

Courier Press, Leamington Spa, England.

# 0011974

## Programmable memory device provided with test means

The present invention relates to a programmable device and, more particularly, a programmable device capable of being programmed in the field by its eventual user but which is also capable of being tested during its manufacture. The programmable devices to which the present invention relates include, for example, a ROM (Read Only Memory), a PROM (Programmable Read Only Memory) and a FPLA (Field Programmable Logic Array).

Such devices usually include an array of memory cells together with a number of peripheral circuits which are used to address, program and read-out the memory cell array. In the existing systems for testing programmable devices only tests for a limited number of faults in the peripheral circuits are possible and it is impossible to carry out a completely comprehensive range of tests covering all the various types of faults that may possibly occur in the peripheral circuit and this makes it difficult to carry out reliable testing of the programmable devices before they have been programmed.

To overcome these problems, test memory cells have been included in programmable devices. These test memory cells have been arranged adjacent the regular memory cells and a separate test bit line, or test word line, is also included with the test memory cells connected between the test bit line, or test word line, and the regular word lines or regular bit lines, respectively. Initially, all of the test cells were of the same conductivity type and of a type opposite to that of the unprogrammed regular memory cells. This naturally enabled some testing of the peripheral circuits to be made but did not enable all the functions of the peripheral circuits to be tested. The next proposal was to arrange for the test memory cells to be formed by a mixture of conducting and non-conducting test cells with the conducting and non-conducting test memory cells being arranged alternately. This arrangement naturally enables the peripheral circuits to be checked to ensure that they can handle signals resulting from both conducting and non-conducting test cells but only enables half of the regular word lines to be checked for an open circuit and the other half of the regular word lines to be checked for the existence of a short circuit. In an attempt to overcome this problem, the number of test memory cells has been increased as has the number of test bit and test word lines. Consequently, the most recent proposals are for the device to include a number of test memory cells arranged along two test bit lines and two test word lines and connected between the test bit and test word lines and the regular word lines and regular bit lines respectively. The memory cells arranged along at least one of each of the test bit and test word lines have included a mixture of conducting and non-conducting test memory cells but usually the test memory cells connected to the other test bit or test word line have all been of the same conductivity type. However, even this arrangement does not enable each and every function of the peripheral circuit to be checked for each and every regular bit line or each and every regular word line and the present invention sets out to provide a programmable device which is capable of being tested comprehensively before it is programmed.

According to this invention, a field programmable device includes a memory cell member having regular bit lines and regular word lines with regular memory cells connected at the crossing points of the regular bit lines and the regular word lines, at least two test lines adjacent the regular bit lines or regular word lines, an address inverter having first inverters for receiving two address signals and second inverters for receiving the output signals from the first inverters, gates for providing a selected word line or a selected bit line with a selection signal in accordance with the output signals from the inverters, and test memory cells connected at the crossing points of the test lines and the regular bit lines or the regular word lines, each test line including a mixture of at least two conducting and at least two non-conducting test memory cells, every one of the regular bit lines or regular word lines having both a conducting and a non-conducting test memory cell connected to it, the test memory cells being arranged along each test line so that the sequence of the conducting and non-conducting test memory cells addressed by a sequence of the two address signals in the order of logical increment consists of first and second half portions with the first half portion being the logical complement of the second half portion.

Preferably the device has additional address signals with the conducting and non-conducting test memory cells being arranged along each of said two test lines such that the sequence of the test memory cells addressed in the order of logical increment due to the introduction of each additional address signal is the logical complement of the sequence of test memory cells corresponding to the other address signals.

Thus, with this arrangement, taking the case of three address signals, if the sequence of the test cells addressed by the first and second address signals consists of cells in the sequence of NC, C, C, NC, where C represents a conducting cell and NC a non-conducting cell, then the sequence of the test cells addressed by the first to the third address signals consists of cells in the sequence of NC, C, C, NC, C, NC, NC, C, so that the sequence of the cells in the first half is the logical complement of those in the second half. With this arrangement each and every regular word line or regular bit line of the programmable device and the peripheral circuits connected to these can be tested with a conducting and a non-conducting test memory cell connected to them and, moreover, each address signal of an address decoder can also be checked for both its states.

2

Particular examples of programmable devices in accordance with this invention will now be described and contrasted with the prior art with reference to the accompanying drawings; in which:—

Figure 1 is a block diagram of a conventional programmable device;

Figure 2 is a circuit diagram of the arrangement of the memory cells in the memory cell array of a conventional programmable device including test memory cells;

Figure 3 is a circuit diagram of the address inverter corresponding to an address signal used in a conventional programmable device;

Figure 4 is a circuit diagram of an example of the connection of test memory cells to a test bit line in a conventional programmable device;

Figure 5 is a circuit diagram of part of an example illustrating the connection of test memory cells to a test bit line for a single address signal input to help explain the present invention;

Figure 6 is a circuit diagram of part of an example in accordance with this invention illustrating the connection of test memory cells to a test bit line for two address signal inputs;

Figure 7 illustrates the arrangement of test memory cells connected to a test bit line for four address signal inputs to further explain the present invention;

Figure 8 is a circuit diagram of part of an example in accordance with the present invention illustrating the arrangement of test memory cells connected to test bit lines to enable the carrying out of an alternating current characteristic test;

Figure 9 is a circuit diagram showing an arrangement of test memory cells connected to a test bit line to enable the detection of a short-circuit in conductors of the device;

Figure 10 is a logic circuit diagram of a circuit for selecting test word lines or test bit lines which is particularly suitable for testing the programmable device in accordance with the present invention;

Figure 11 is a logic circuit diagram of a conventional circuit for selecting test word lines or test bit lines; and

Figures 12 and 13 are circuit diagrams showing the arrangement of test memory cells connected to test word lines for eliminating an incorrect test caused by a leakage of current in the device in accordance with the present invention.

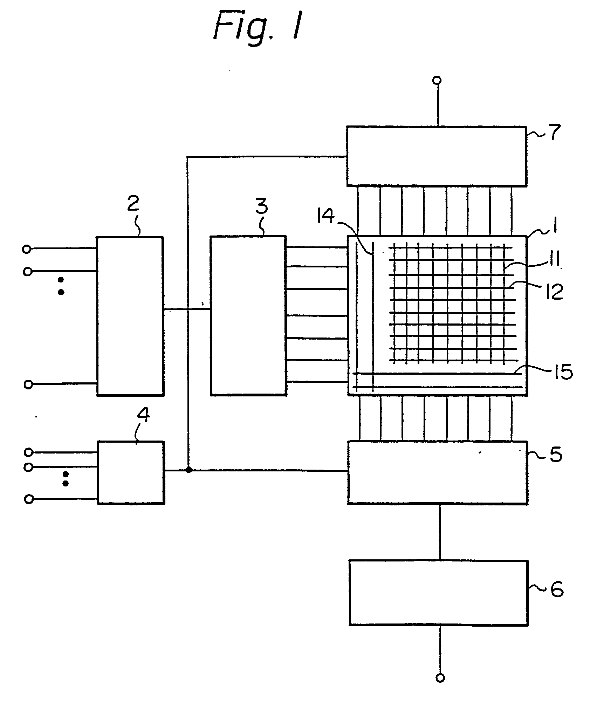

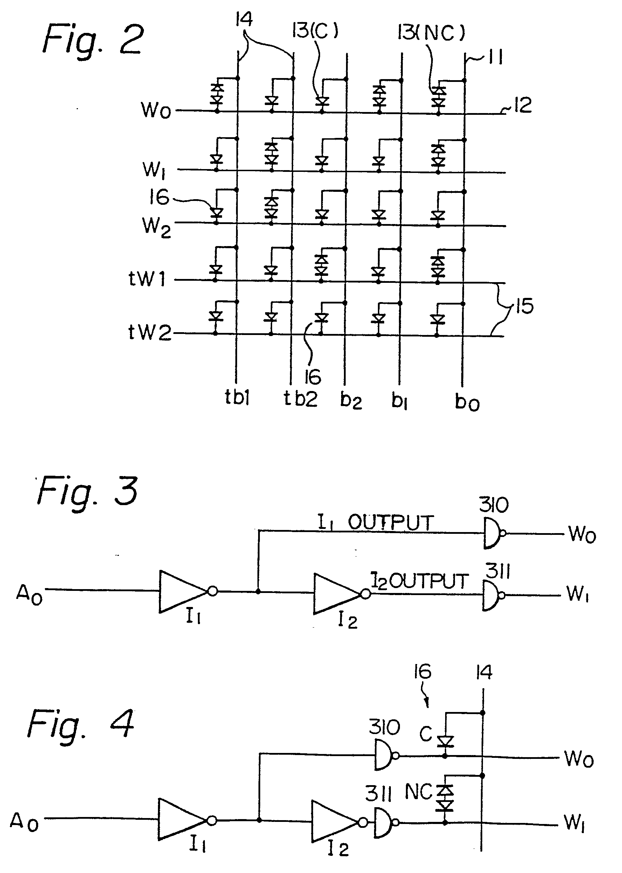

A programmable device, in general, as illustrated in Figure 1, comprises a memory cell array 1, an X-direction address inverter 2, a Y-direction address inverter 4, an X-direction decoder driver 3, a multiplexer 5, a programming circuit 7 and an output circuit 6. In the memory cell array 1, regular memory cells 13 are connected between bit lines 11 and word lines 12 at crossing points of the bit lines 11 and the word lines 12. Before forwarding this programmable device to a user, it is necessary to test it to check for faults in the peripheral circuits, such as the X- and Y- direction address inverters 2, 4, the decoder driver 3, the programming circuit 7, the multiplexer 5 and the output circuit 6. The regular memory cells 13 in the memory cell array 1 are in their original state in which no writing-in of information has occurred when the programmable device including the memory cell array 1 is supplied from a manufacturer to a user. Therefore it is necessary to provide test bit lines 14, test word lines 15 and test memory cells 16 adjacent the group of the bit lines 11 and the word lines 12 for enabling the detection of faults in the peripheral circuits. In the past these test memory cells 16 have been selectively placed in a conducting or non-conducting state as a result of applications of predetermined data signals as shown in Figure 2.

One conventional arrangement of the test memory cells 16 is illustrated in Figure 4. Figure 3 illustrates the circuit of the address inverter 2 formed by inverters $I_1$ and $I_2$. Now analysing the possible defective operations in inverters $I_1$ and $I_2$ of the address inverter 2, it is possible for an inverter to be in one of three states: the normal state, an abnormal state in which the output signal of the inverter is always "1" (a fixed "1"), and an abnormal state in which the output signal of the inverter is always "0" (a fixed "0"). The possible combinations of the states of the inverter $I_1$ and the inverter $I_2$ are shown in Table 1, below.

3

TABLE 1

| Case No | $I_1$ | $I_2$ |
|---------|-------|-------|
| 1 | normal | normal |
| 2 | normal | fixed "1" |
| 3 | normal | fixed "0" |
| 4 | fixed "1" | normal |
| 5 | fixed "1" | fixed "1" |
| 6 | fixed "1" | fixed "0" |
| 7 | fixed "0" | normal |
| 8 | fixed "0" | fixed "1" |
| 9 | fixed "0" | fixed "0" |

With regard to the circuit of Figure 3, the outputs of the inverters $I_1$ and $I_2$ in accordance with the signals "1" and "0" of the address input $A_0$ are tabulated in Table 2, below, as they correspond to each of the case numbers 1 to 9 of Table 1.

TABLE 2

| Case No. | $I_1$ Output | | $I_2$ Output | |
|----------|--------------|--------------|--------------|--------------|
| | $A_0$="1" | $A_0$="0" | $A_0$="1" | $A_0$="0" |
| 1 | "0" | "1" | "1" | "0" |
| 2 | "0" | "1" | "1" | "1" |
| 3 | "0" | "1" | "0" | "0" |
| 4 | "1" | "1" | "0" | "0" |
| 5 | "1" | "1" | "1" | "1" |
| 6 | "1" | "1" | "0" | "0" |
| 7 | "0" | "0" | "1" | "1" |
| 8 | "0" | "0" | "1" | "1" |
| 9 | "0" | "0" | "0" | "0" |

Figure 4 illustrates the case where a conductive test memory cell C is connected between a word line $W_0$ and the test bit line 14, and a non-conductive test memory cell NC is connected between a word line $W_1$ and the test bit line 14. The word line $W_0$ is connected through a NAND gate 310 to the output of the inverter $I_1$ and the word line $W_1$ is connected through a NAND gate 311 to the output of the inverter $I_2$. The conduction or the non-conduction of a current from the test bit lines to either of the word lines $W_0$ and $W_1$ in accordance with signals "1" and "0" of the address input $A_0$ are tabulated in Table 3, below, as they correspond to each of the Case Nos. 1 through 9 of Table 2. It should be noted the conduction occurs only through a conductive test memory cell C connected between the test bit line 14 and a word line only when the level of said word line is "0".

4

TABLE 3

| Case No | $A_0$="1" | $A_0$="0" |
|---------|-----------|-----------|
| 1 | Non-conduction | Conduction |
| 2 | Non-conduction | Conduction |
| 3 | Non-conduction | Conduction |
| 4 | Conduction | Conduction |
| 5 | Conduction | Conduction |
| 6 | Conduction | Conduction |
| 7 | Non-conduction | Non-conduction |
| 8 | Non-conduction | Non-conduction |
| 9 | Non-conduction | Non-conduction |

Table 3 indicates that it is impossible to identify the Case No 1, which corresponds to the normal states of both inverters $I_1$ and $I_2$ (table 1), because the combination of the Non-conduction for $A_0$="1" and the Conduction for $A_0$="0" occurs identically in the Case No 2 and the Case No 3. Accordingly, it is impossible to detect the defective operations of the inverters $I_1$ and $I_2$ by means of the conventional connections of the test memory cells as illustrated in Figure 4.

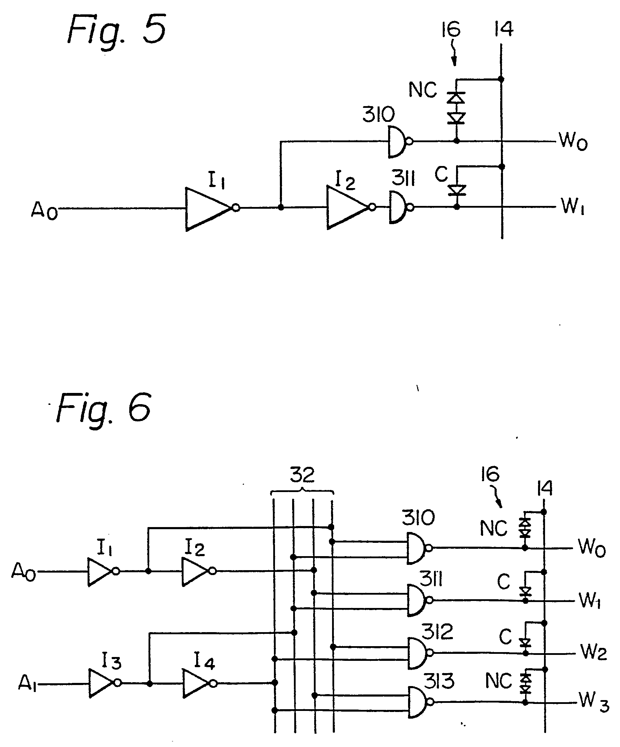

In an example of a field programmable device in accordance with the present invention two test bit lines 14 are provided and both of these test bit lines 14 contain a mixture of conducting (C) and non-conduction (NC) test memory cells 16 arranged so that each and every regular word line 12 has connected to it both a conducting C and a non-conducting NC test memory cell 16. Moreover, the particular arrangement of the conducting C and non-conducting NC test memory cells 16 along each test bit line 14 is selected so that the full functional operation of the address inverter $I_1$ and $I_2$ can be checked. Figure 5 illustrates the trivial case of a single address input signal to demonstrate how the conducting C and non-conducting NC test memory cells 16 are arranged. Of course, in practice there are a plurality of address input signals. Also for clarification the second test bit line 14 has been omitted from Figures 5, 6 and 7.

A non-conducting NC test memory cell 16 is connected between the word line $W_0$ and the test bit line 14 and a conductive C test memory cell 16 is connected between the word line $W_1$ and the test bit line 14. The word line $W_0$ is connected through a NAND gate 310 to the output of the inverter $I_1$ and the word line $W_1$ is connected through a NAND gate 311 to the output of the inverter $I_2$. A word line is selected when the level of that word line is caused to be "0" level in accordance with address signals. In this case the following table 4 is obtained.

TABLE 4

| Case No. | $A_o$ = "1" | $A_o$ = "0" |
|----------|-------------|-------------|
| 1 | Conduction | Non-conduction |
| 2 | Conduction | Conduction |
| 3 | Non-conduction | Non-conduction |
| 4 | Non-conduction | Non-conduction |
| 5 | Conduction | Conduction |
| 6 | Non-conduction | Non-conduction |
| 7 | Conduction | Conduction |
| 8 | Conduction | Conduction |
| 9 | Non-conduction | Non-conduction |

In Table 4, the combination of the conduction for $A_0$="1" and the non-conduction for $A_0$="0" only occurs in the case No 1. This indicates that it is possible to distinguish the case No 1, which corresponds to the normal states of both inverters $I_1$ and $I_2$ and accordingly, it is possible to detect a fault in the address inverter with the aid of the test memory cells arranged in the particular way illustrated in the test bit line 14.

To enable this system to operate in the non-trivial case where there are a plurality of address inputs the arrangement of the conducting C and non-conducting NC test memory cells 16 along each of the test bit lines 14 is such that the sequence in which the test cells are addressed in the order of logical increment due to the introduction of each additional address signal is the logical complement of the sequence of test cells corresponding to the other address signals.

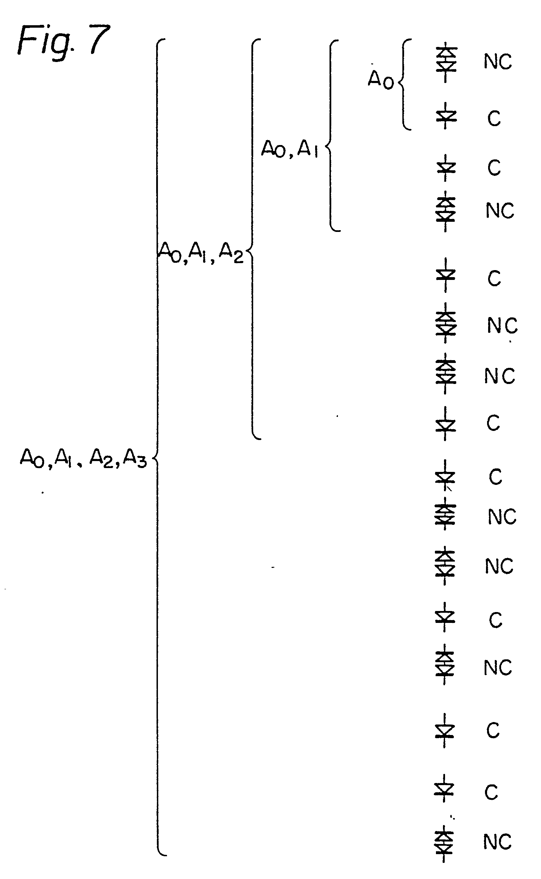

Examples of the case where the number of the address inputs is N are illustrated in Figures 6 and 7. The number of the address inputs is two in the example shown in Figure 6 and four in the example shown in Figure 7. In the Figure 6 arrangement the address 00 applies a 0 to the address input $A_0$ and a 0 to address input $A_1$, with 0's applied to both of these address inputs the word line $W_0$ is selected. The address 01 selects the word line $W_1$, address 10 selects the word line $W_2$, and address 11 selects the word line $W_3$. Thus as the addresses are incremented from 00 to 11 the sequence in which the test cells 16 are addressed is NC C C NC. In Figure 6, the test memory cells 16 connected to the word lines $W_2$ and $W_3$, which are added to the arrangement shown in Figure 5 in accordance with the second address input $A_1$ are in the sequence C, NC and this is the logical complement of the order "NC, C" of the test memory cells connected to the word lines $W_0$ and $W_1$.

In Figure 7, the order "C, NC, NC, C" from the fifth test memory cell to the eighth test memory cell, which are added in accordance with the third address input $A_2$, is the logical complement of the order "NC, C, C, NC" from the first test memory cell to the fourth test memory cell, which correspond to the first and the second address inputs $A_0$ and $A_1$. Also, the order "C, NC, NC, C, NC, C, C, NC" from the ninth test memory cell to the sixteenth test memory cell, which are added in accordance with the fourth address input $A_3$, is the logical complement of the order "NC, C, C, NC, C, NC, NC, C" from the first test memory cell to the eighth test memory cell, which correspond to the first, the second and the third address inputs $A_0$, $A_1$, and $A_2$.

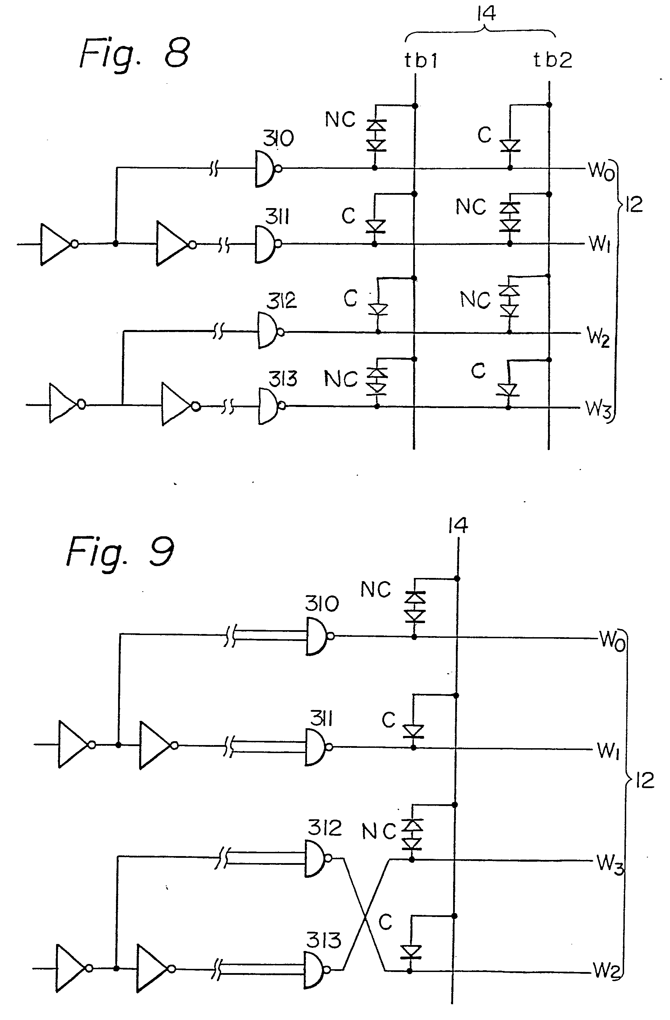

To enable the rise time or fall time of the output signals of the logic circuits of the device to be monitored, each word line 12 must have connected to it both a conducting C and non-conducting NC test memory cell 16. This arrangement is illustrated in Figure 8. In the circuit of Figure 8, a first test bit line tb1 and a second test bit line tb2 are provided and the conductivity of a test memory cell connected to the second test bit line tb2 is the logical complement of a test memory cell connected to the first test bit line tb1. For example, a conductive test memory cell C is connected between the word line $W_0$ and the test bit line tb2, while a non-conductive test memory cell NC is connected between the word line $W_0$ and the test bit line tb1. Thus, at least one conductive test memory cell is connected to each of the word lines and at least one non-conducting cell is also connected to each of the word lines. In the circuit of Figure 8, the test of the alternate current characteristic and the writing-in abilities for the entire decoder drivers and the address inverters is performed with the aid of the two test bit lines. If no second test bit line is provided conductive test memory cells are connected to only one half of all the word lines and in such a case, only a test for one half of all the decoder drivers is possible.

It is preferable to eliminate an incorrect test caused by a short circuit of the conductors in a field programmable device under test. The circuit for eliminating such an incorrect test in accordance with an embodiment of the present invention is illustrated in Figure 9. In the circuit of Figure 9, one of the neighbouring word lines, to both of which the test memory cells of the same conductivity are connected respectively, exchanges its position with the next word line. That is, in the case where the order of the test memory cells is "NC, C, C, NC", corresponding to the word lines $W_0$, $W_1$, $W_2$ and $W_3$, the order of the word lines is caused to be $W_0$, $W_1$, $W_3$, $W_2$" by exchanging the position of the word line $W_2$ and $W_3$. In the circuit of Figure 9, an incorrect test due to a short circuit between, for example, the neighbouring word lines $W_1$ and $W_3$ is eliminated, because a short circuit between the word lines $W_1$ and $W_3$ can be detected because of the reverse conductivity between the test memory cells connected to the word lines $W_1$ and $W_3$.

If the original order "$W_0$, $W_1$, $W_2$, $W_3$" of the word lines is maintained, an incorrect test result is obtained when a short circuit occurs between the word lines $W_1$ and $W_2$, to both of which the memory cells of the same conductivity are connected.

The above explanations of the examples of the present invention with reference to Figs. 5, 6, 7, 8 and 9 are set forth mainly with respect to test bit lines. However, the present invention is also applicable to a field programmable device which provides test word lines and test memory cells connected between the test word lines and the bit lines.

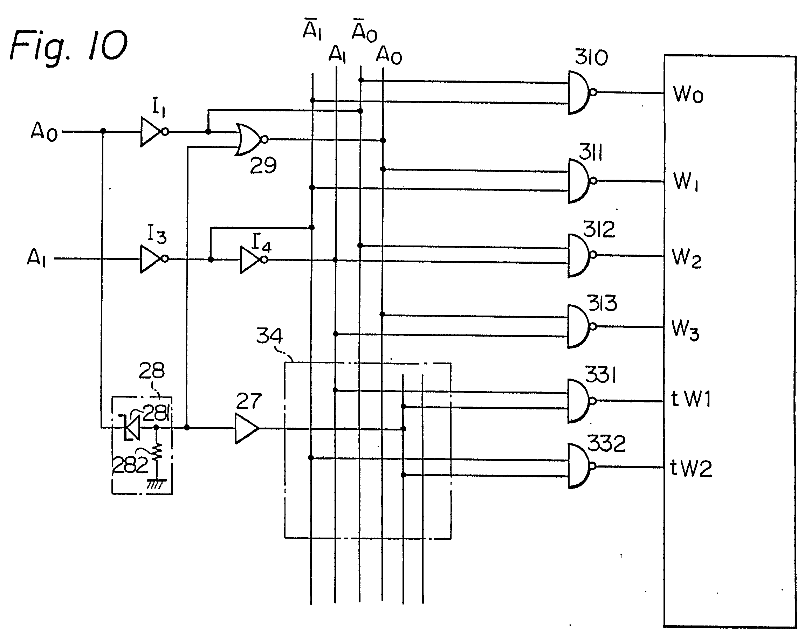

A logic circuit for selecting a test word line or a test bit line which is particularly suitable for the above described embodiments of the present invention is illustrated in Fig. 10. In the circuit of Fig. 10 a level sensing circuit 28 consisting, for example, of a zener diode 281 and a resistor 282 is connected to the address signal input $A_0$, and a NOR gate 29 is connected to the output of the inverter $I_1$, connected to the address signal input $A_0$. The output of the level sensing circuit 28 is supplied to an input of the NOR gate 29. NAND gates 331, 332 of the decoder driver, which are selected by the output signal of the level sensing circuit and the output signal of the address inverter, are connected to the test word lines tw1 and tw2. For address signal inputs $A_0$, $A_1$, in addition to the ordinary "0" signal and "1" signal, a third signal "1H", which is higher than "1" and makes the level sensing circuit produce a signal as high as "1", is used for selecting the test word lines tw1 and tw2.

In the circuit of Fig. 10 the address signal input $A_0$ is caused to be "1H" in order to select the test word lines tw1 and tw2. Then, the output of the level sensing circuit 28 becomes "1", after which the output of the NOR gate 29 becomes "0", and the output of the inverter $I_1$, is "0". Accordingly, at least one input of each of the NAND gates 310, 311, 312 and 313 is "0", and therefore, none of the word lines $W_0$, $W_1$, $W_2$ and $W_3$ is selected. The output signal "1" of the level sensing circuit is supplied to the amplifier 27, and accordingly, an input of each of the NAND gates 331 and 332 becomes "1". In this case, if the address signal input $A_1$ is "0", the output of the NAND gate 332 is caused to be "0", and accordingly, the test word line tw2 is selected; while, if the address signal input $A_1$ is "1", the output of the NAND gate 331 is caused to be "0", and accordingly, the test word line tw1 is selected.

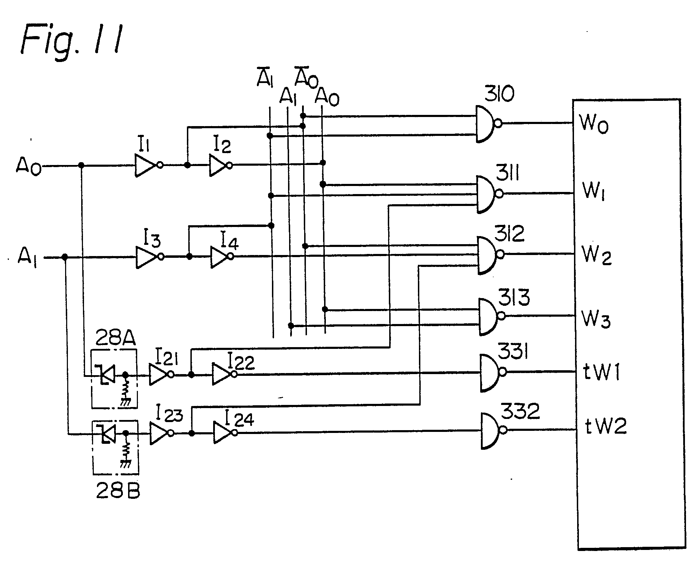

If this circuit of Fig. 10 is not used, disadvantages in the production of the field programmable device are unavoidable. These disadvantages are explained with reference to a prior art circuit illustrated in Fig. 11. In the circuit of Fig. 11, the level sensing circuit 28A and 28B are connected to the address signal inputs $A_0$ and $A_1$, respectively. When the address signal input $A_0$ is "1H", the output of the inverter $I_{21}$ is caused to be "0" and the output "0" of the inverter $I_{21}$ is supplied to the NAND gate 311, and accordingly, no selection of the word line $W_1$ is effected. While, when the address signal input $A_1$ is "1H", the output of the inverter $I_{23}$ is caused to be "0" and the output "0" of the inverter $I_{23}$ is supplied to the NAND gate 312, and accordingly, no selection of the word line $W_2$ is effected. In this way, in the circuit of Fig. 11 it is possible to perform the selection of the test word line. However, in the circuit of Fig. 11 it is necessary to provide a level sensing circuit and inverters for each of the address signal inputs, and connecting conductors between the outputs of level sensing circuits and inputs of the NAND gates of the decoder driver. This results in the disadvantages of a reduction of the degree of integration of the integrated circuit of the field programmable device and an increase in the cost of production of the field programmable device, because the number of the circuit elements is increased and the circuit connections become complicated.

Although the circuit of Fig. 10 is used for selection of the test word line, it is possible to construct a similar circuit for selecting the test bit line. Also, although the circuit of Fig. 10 is applicable to the device having two test word lines, it is also possible to construct a circuit which is applicable to the device having three or more than three test word lines.

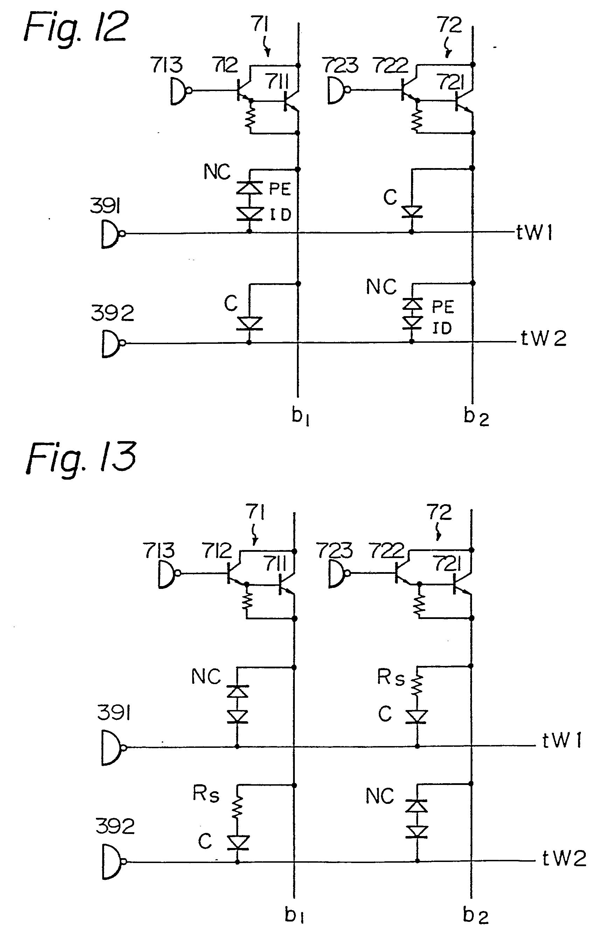

A modified structure which may be applied to the above described embodiments of the present invention for eliminating an incorrect test due to current leakage in the device is illustrated in Figs. 12 and 13. In the circuits of Figs. 12 and 13 writing-in currents are supplied through programming circuits 71, 72 to test memory cells, having either a conductive (C) or non-conductive (NC) characteristic, which are connected at the cross points of the test word lines tw1, tw2 and the bit lines $b_1$, $b_2$. In the circuit of Fig. 11, the structure of the non-conductive (NC) test memory cells is such that no writing-in is effected by the regular writing-in current for the regular memory cells 13 connected at the cross points of the bit lines 11 and the word lines 12 (Fig. 2). This structure is determined by, for example, the area of the emitter, the depth of the base or melting point of the electrode material of the programmable element (PE) of the non-conductive test memory cell (NC). When the structure is determined by the area of the emitter, the area of the emitter of the programmable element (PE) of the test memory cell is greater than that of the regular memory cell. In the circuit of Fig. 12 no writing-in of the non-conductive test memory cell is effected by supplying a test writing-in current of, for example, 12 mA. Accordingly, it is possible to perform the test by using this non-conductive test memory cell in which no writing-in is effected.

In the circuit of Fig. 13 a resistor $R_s$ is connected in series with the conductive test memory (C). It is possible to detect a current leakage in programming circuits 71, 72, which occurs only when the applied voltage exceeds a predetermined value, by using the voltage drop across the resistor $R_s$ when the test current passes through the resistor $R_s$. Accordingly, it is possible to perform the test by using these series connected conductive test memory cell and the resistor.

If the circuits of Figs. 12 and 13 are not used, an incorrect test due to current leakage in the device is unavoidable. The reason for the incorrect test can be explained by assuming that there is a defect causing current leakage only when the applied voltage exceeds a predetermined level in the programming circuits. In such a case, when writing-in by the regular writing-in current to the test memory cell is effected, it is possible to perform the test because the test is performed by passing the current through the conductive element without causing current leakage in the programming circuits. However, it is impossible to effect the writing-in of the regular memory cells because of the interruption of the collector current of transistors 711, 721 of the programming circuits 71, 72 due to the shortage of the base current of said transistors 711, 712. Similarly, if no resistor is connected in series with the conductive test memory cell, it is impossible to perform the correct test.

Although the above explanation of the examples of the present invention is mainly directed to the operation of the X-direction address inverter and the X-direction decoder driver, it is possible to apply the present invention to a field programmable device using the Y-direction address inverter, the Y-

7

direction decoder driver and the multiplexer.

**Claims**

1. A field programmable device including a memory cell member (1) having regular bit lines (11) and regular word lines (12) with regular memory cells (13) connected at the crossing points of the regular bit lines (11) and the regular word lines (12), at least two test lines (14 or 15) adjacent the regular bit lines (11) or regular word lines (12), an address inverter (2, 4) having first inverters ($I_1$, $I_3$) for receiving two address signals ($A_0$, $A_1$) and second inverters ($I_2$, $I_4$) for receiving the output signals from the first inverters ($I_1$, $I_3$), gates (310—313) for providing a selected word line (12) or a selected bit line (11) with a selection signal in accordance with the output signals from the inverters ($I_1$, $I_2$, $I_3$, $I_4$), and test memory cells (16) connected at the crossing points of the test lines (14 or 15) and the regular bit lines (11) or the regular word lines (12), each test line (14 or 15) including a mixture of at least two conducting (C) and at least two non-conducting (NC) test memory cells (16), every one of the regular bit lines (11) or regular word lines (12) having both a conducting (C) and a non-conducting (NC) test memory cell (16) connected to it, the test memory cells (16) being arranged along each test line (14 or 15) so that the sequence (NC, C, C, NC) of the conducting (C) and non-conducting (NC) test memory cells (16) addressed by a sequence of the two address signals ($A_0$, $A_1$) in the order of logical increment consists of first and second half portions with the first half portion being the logical complement of the second half portion.

2. A field programmable device according to claim 1, modified by having additional address signals (Figure 7), the conducting (C) and non-conducting (NC) test memory cells being arranged along each of said two test lines (14, 15) such that the sequence of the test memory cells addressed in the order of logical increment due to the introduction each additional address signal is the logical complement of the sequence of test cells corresponding to the other address signals.

3. A programmable device according to claim 1 or 2, wherein the geometrical layout of the regular word lines (12) or regular bit lines (13), the conducting (C) and the non-conducting (NC) test memory cells (16) is arranged so that conducting test memory cells (C) and non-conducting test memory cells (NC) are located alternately along the test lines.

4. A programmable device according to claim 1, 2 or 3, in which the programmable element of the non-conducting (NC) test memory cell (16) is arranged so that no writing-in of information occurs when it is addressed by the writing-in current for a regular memory cell (13).

5. A programmable device according to any one of the preceding claims, in which resistors are connected in series with the conducting (C) test memory cells (16).

6. A programmable device according to any one of the preceding claims, which also includes a logic circuit comprising a level sensing circuit (28) connected to an address signal input ($A_0$) for producing a high level output (1H) when a signal having a level higher than the high level (1) is applied to the address signal input, a NOR gate (29) connected to the output of an inverter ($I_1$) connected to the address signal input ($A_0$), the output of the level sensing circuit (28) being applied to an input of the NOR gate (29) and decoders (31, 32 etc) which are connected to the test lines (14, 15) and are supplied with the output signals from the level sensing circuit (28).

**Revendications**

1. Un dispositif programmable par l'utilisateur comprenant un ensemble de cellules de mémoire (1) ayant des lignes de bit normales (11) et des lignes de mot normales (12), avec des cellules de mémoire normales (13) connectées aux points d'intersection des lignes de bit normales (11) et des lignes de mot normales (12), au moins deux lignes de test (14 ou 15) adjacentes aux lignes de bit normales (11) ou aux lignes de mot normales (12), un inverseur d'adresse (2, 4) comportant des premiers inverseurs ($I_1$, $I_3$) destinés à recevoir deux signaux d'adresse ($A_0$, $A_1$) et des seconds inverseurs ($I_2$, $I_4$) destinés à recevoir les signaux de sortie des premiers inverseurs ($I_1$, $I_3$), des portes (310, 313) destinées à appliquer un signal de sélection comforme aux signaux de sortie des inverseurs ($I_1$, $I_2$, $I_3$, $I_4$) sur une ligne de mot sélectionnée (12) ou une ligne de bit sélectionée (11), et des cellules de mémoire de test (16) connectées aux points d'intersection des lignes de test (14 ou 15) et des lignes de bit normales (11) ou des lignes de mot normales (12), chaque ligne de test (14 ou 15) comprenant un mélange d'au moins deux cellules de mémoire de test (16) conductrices (C) et d'au moins deux cellules de mémoire de test (16) non conductrices (NC), chacune des lignes de bit normales (11) ou des lignes de mot normales (12) étant connectée à la fois à une cellule de mémoire de test (16) conductrice (C) et à une cellule de mémoire de test (16) non conductrice (NC), et les cellules de mémoire de test (16) étant disposées le long de chaque ligne de test (14 ou 15) de façon que la séquence (NC, C, C, NC) des cellules de mémoire de test (16) conductrices (C) et non conductrices (NC) qui sont adressées par une séquence des deux signaux d'adresse ($A_0$, $A_1$), dans l'ordre de progression logique, soit constituée par des première et seconde moitiés, la première moitié étant le complément logique de la seconde moitié.

2. Un dispositif programmable par l'utilisateur selon la revendication 1, modifié par le fait qu'il comporte des signaux d'adresse supplémentaires (figure 7), les cellules de mémoire de test conductrices (C) et non conductrices (NC) étant disposées le long de chacune des deux lignes de test (14 ou 15) de façon que la séquence des cellules de mémoire de test qui sont adressées dans l'ordre de progression logique, sous l'effet de l'introduction de chaque signal d'adresse supplémentaire, soit le complément logique de la séquence de cellules de test correspondant aux autres signaux d'adresse.

3. Un dispositif programmable selon la revendication 1 ou 2, dans lequel la configuration géométrique des lignes de mot normales (12) ou des lignes de bit normales (13) et des cellules de mémoire de test (16) conductrices (C) et non conductrices (NC) est telle que des cellules de mémoire de test conductrices (C) et des cellules de mémoire de test non conductrices (NC) soient placées en alternance le long des lignes de test.

4. Un dispositif programmable selon la revendication 1, 2 ou 3, dans lequel l'élément programmable de la cellule de mémoire de test (16) non conductrice (NC) est conçu de façon qu'aucune écriture d'information n'ait lieu lorsqu'il est adressé par le courant d'écriture pour une cellule de mémoire normale (13).

5. Un dispositif programmable selon l'une quelconque des revendications précédentes, dans lequel des résistances sont connectées en série avec les cellules de mémoire de test (16) non conductrices (C).

6. Un dispositif programmable selon l'une quelconque des revendications précédentes, comprenant également un circuit logique qui comporte un circuit de détection de niveau (28) connecté à une entrée de signal d'adresse ($A_0$) pour produire un signal de sortie de niveau haut (1H) lorsqu'un signal ayant un niveau plus élevé que le niveau haut (1) est appliqué à l'entrée de signal d'adresse, une porte NON—OU (29) connectée à la sortie d'un inverseur ($I_1$) lui-même connecté à l'entrée de signal d'adresse ($A_0$), le signal de sortie du circuit de détection de niveau (28) étant appliqué à une entrée de la porte NON—OU (29), et des décodeurs (31, 32, etc) qui sont connectés aux lignes de test (14, 15) et qui reçoivent les signaux de sortie provenant du circuit de détection de niveau (28).

## Patentansprüche

1. Vor Ort bzw. bei Bedarf programmierbare Vorrichtung mit einer Speicherzellenanordnung (1), welche reguläre Bitleitungen (11) und reguläre Wortleitungen (12) mit regulären Speicherzellen (13) aufweist, welche an den Kreuzungspunkten der regulären Bitleitungen (11) und der regulären Wortleitungen (12) angeschlossen sind, mit wenigstens zwei Testleitungen (14 oder 15) neben den regulären Bitleutungen (11) oder regulären Wortleitungen (12), mit einem Adresseninverter (2, 4) mit ersten Inverten ($I_1$, $I_3$) zum Empfang von zwei Adressensignalen ($A_0$, $A_1$) und zweiten Invertern ($I_2$, $I_4$) zum Empfang von Ausgangssignalen von den ersten Invertern ($I_1$, $I_3$), mit Verknüpfungsgliedern (310, 313), welche, in Übereinstimmung mit den Ausgangssignalen von den Invertern ($I_1$, $I_2$, $I_3$, $I_4$), einer ausgewählten Wortleitung (12) oder einer ausgewählten Bitleitung (11) ein Auswahlsignal liefern, und mit Testspeicherzellen (16), welche mit den Kreuzungspunkten der Testleitungen (14 oder 15) und den regulären Bitleitungen (11) oder den regulären Wortleitungen (12) verbunden sind, wobei jede Testleitung (14 oder 15) eine Mischung von wenigstens zwei leitenden (C) und wenigstens zwei nicht-leitenden (NC) Testspeicherzellen (16) umfaßt, jede der regulären Bitleitungen (11) oder der regulären Wortleitungen (12) sowohl mit einer leitenden (C) als auch mit einer nicht-leitenden (NC) Testspeicherzelle (16) verbunden ist, die Testspeicherzellen (16) längs jeder Testleitung (14 oder 15) so angeordnet sind, daß die Folge (NC, C, C, NC) der leitenden (C) und der nicht-leitenden (NC) Testspeicherzellen (16) durch eine Folge von den beiden Adressensignalen ($A_0$, $A_1$) in Reihenfolge des logischen Inkrements adressiert werden, welches aus ersten und zweiten Hälften besteht, von denen die erste Hälfte das logische Komplement der zweiten Hälfte ist.

2. Vor Ort bzw. bei Bedarf programmierbare Vorrichtung nach Anspruch 1, modifiziert durch zusätzliche Adressensignale (Fig. 7), bei welcher die leitenden (C) und die nicht-leitenden (NC) Testspeicherzellen so längs jeder der genannten beiden Testleitungen (14 oder 15) angeordnet sind, daß die Folge der Testspeicherzellen, welche in der Reihenfolge des logischen Inkrements adressiert sind, aufgrund der Einführung jedes zusätzlichen Adressensignals, das logische Komplement der Folge von Testzellen ist, welche den anderen Adressensignalen entsprechen.

3. Programmierbare Vorrichtung nach Anspruch 1 oder 2, bei welcher die geometriche Auslegung der regulären Wortleitungen (12) oder regulären Bitleitungen (13), der leitenden (C) und der nicht-leitenden (NC) Testspeicherzelle (16) so angeordnet sind, daß die leitenden Testspeicherzellen (C) und die nicht-leitenden Testspeicherzellen (NC) alternativ längs den Testleitungen angeordnet sind.

4. Programmierbare Vorrichtung nach einem der Ansprüche 1, 2 oder 3, bei welcher das programmierbare Element der nicht-leitenden (NC) Speicherzelle (16) so angeordnet ist, daß keine Information auftritt, wenn sie durch einen Schreibstrom für eine reguläre Speicherzelle (13) adressiert wird.

5. Programmierbare Vorrichtung nach einem der vorhergehenden Ansprüche, bei welcher widerstände in Reihe mit den leitenden (C) Testspeicherzellen (16) geschaltet sind.

6. Programmierbare Vorrichtung nach einem der vorhergehenden Ansprüche, welche ferner eine Logikschaltung enthält, welche einen Pegelsensorkreis (28) umfaßt, der mit einem Adressensignaleingang ($A_0$) zur Erzeugung eines Großsignalausgangs (1H) verbunden ist, wenn ein Signal mit einem höheren Pegel als der Großsignalpegel (1) dem Adressensignaleingang zugeführt wird, mit einem NOR-Glied (29), welches mit dem Ausgang eines Inverters ($I_1$) verbunden ist, der mit dem Adressensignaleingang ($A_0$) verbunden ist, wobei der Ausgang des Pegelsensorkreises (28) einem Eingang des NOR-Gliedes (29) zugeführt wird, und mit Decodern (31, 32 etc.), die mit den Testleitungen (14, 15) verbunden sind und denen die Ausgangssignale von dem Pegelsensorkreis (28) zugeführt werden.

# Fig. I

*Fig. 2*

*Fig. 3*

*Fig. 4*

*Fig. 5*

*Fig. 6*

*Fig. 7*

$A_0, A_1, A_2, A_3$ {  $A_0, A_1, A_2$ {  $A_0, A_1$ {  $A_0$ { NC

C

C

NC

C

NC

NC

C

C

NC

NC

C

NC

C

C

NC

**0011974**

**Fig. 8**

**Fig. 9**

Fig. 10

0011974

**0011974**

Fig. 11

7

*Fig. 12*

*Fig. 13*